# EUROPÄISCHE PATENTSCHRIFT

(11) **EP 3 417 243 B1**
(45) Veröffentlichungstag und Bekanntmachung des Hinweises auf die Patenterteilung: **11.12.2019**
(21) Anmeldenummer: 17704409.6
(22) Anmeldetag: 31.01.2017
(51) Int. Cl.: G01D 5/14, G01D 5/244, G01R 33/06

(54) **ANORDNUNG ZUR ERFASSUNG DER WINKELPOSITION EINES DREHBAREN BAUTEILS**
ARRANGEMENT FOR DETECTING THE ANGULAR POSITION OF A ROTATABLE COMPONENT
DISPOSITION POUR ENREGISTRER LA POSITION ANGULAIRE D'UNE PIÈCE ROTATIVE

(30) Priorität: 17.02.2016 DE 102016202378
(43) Veröffentlichungstag der Anmeldung: 26.12.2018
(73) Patentinhaber: Continental Automotive GmbH, 30165 Hannover (DE)
(72) Erfinder: WALLRAFEN, Werner, 65795 Hattersheim (DE)
(86) Internationale Anmeldenummer: PCT/EP2017/052057
(87) Internationale Veröffentlichungsnummer: WO 2017/140495

(56) Entgegenhaltungen:
- WO-A1-2011/036196
- WO-A1-2016/139135
- GB-A- 2 505 226

## Beschreibung

Die vorliegende Erfindung betrifft eine Anordnung zur Erfassung der Winkelposition eines um eine Drehachse drehbaren Bauteils, insbesondere eine Anordnung zur berührungsfreien Erfassung der Winkelposition eines Rotors eines Elektromotors oder die Winkelposition einer Ventilklappe oder eine Drehachse eines Stellglieds.

Zur Erfassung der Winkelposition eines um eine Drehachse drehbaren Bauteils ist es bekannt, magnetisch basierte Winkelsensoren zu verwenden. Die GB 2 505 226 A offenbart beispielsweise eine Anordnung, ein Verfahren und einen Sensor zum Messen einer Winkelposition unter Verwendung eines mehrpoligen Magneten mit Kompensation von magnetischen Stör-/Fremdfeldern. Die darin offenbarte Anordnung weist einen an einem Rotor angebrachten mehrpolpaarigen Magneten und einen feststehenden Sensor auf. Der Sensor umfasst mehrere auf einem Kreis angeordnete Sensorelemente, die im Wesentlichen in zwei Gruppen zum Messen der parallel zur Sensorebene wirksamen Magnetfeldkomponenten angeordnet sind. Durch die darin offenbarte Anordnung können homogene magnetische Stör-/Fremdfelder weitestgehend kompensiert werden. Jedoch wird mit dem segmentierten mehrpolpaarigen Magneten der nutzbare Winkelmessbereich eingeschränkt, so dass nur ein Bereich von 360° geteilt durch die Anzahl der Polpaare des Magneten erfasst werden kann.

Ferner sind aus der EP 0 916 074 B1, US 2015/276893 A1, DE 10 2015 001 553 B3, DE 10 2014 005 247 A1, DE 10 2004 064 185 B4 und der DE 698 16 755 T2 jeweils Vorrichtungen zur Erfassung der Winkelposition eines drehbaren Bauteils bekannt. Auch diese Offenbarungen basieren auf Differenzbildung zur Unterdrückung von magnetischen Stör-/Fremdfeldern. Dabei werden parallele Komponenten des Magnetfelds erfasst und deshalb auch nur diejenigen Magnetfeldkomponenten gemessen, die orthogonal zur Sensorebene wirken. Magnetisch sensitive Sensoren, wie z. B. magnetoresistive Sensoren oder vertikale Hallzellen, die parallel zur Sensorebene messen, können nicht verwendet werden.

Aus der WO 2011/036196 A1 ist ein Verfahren zur Auswertung von Signalen eines Winkelsensors bekannt.

Die WO 2016/139135 A1 betrifft ein Verfahren und eine Anordnung zur Positionsbestimmung eines magnetischen Körpers mittels Magnetfeldsensoren.

Magnetische Stör-/Fremdfelder können durch nahegelegene Permanentmagneten, Elektromagneten oder auch durch eine in der Nähe verlaufende Stromleitung erzeugt werden. Im Zuge der Elektrifizierung von Fahrzeugen, insbesondere im Hinblick auf z. B. das 48-Volt-Bordnetz, in dem Stromstärken von bis zu 1.000 Ampere auftreten können, werden der magnetischen Nutzfeldquelle zunehmend magnetische Stör-/Fremdfelder überlagert, die das Signal des Sensors beeinflussen und somit die Messungen des magnetischen Drehgebers verfälschen können.

Die Aufgabe der vorliegenden Erfindung besteht darin, eine Anordnung bereitzustellen, mit der die Winkelposition eines um eine Drehachse drehbaren Bauteils zuverlässig, möglichst genau und über einen Winkelmessbereich von 360° erfasst werden kann und die robust gegenüber magnetischen Stör-/Fremdfeldern ist.

Diese Aufgabe wird mit den Merkmalen des unabhängigen Anspruchs 1 gelöst. Vorteilhafte Ausgestaltungen sind in den Unteransprüchen angegeben.

Der vorliegenden Erfindung liegt der Gedanke zugrunde, eine Anordnung zur Erfassung der Winkelposition eines um eine Drehachse drehbaren Bauteils vorzusehen, die einen Magneten aufweist, der dazu ausgebildet ist, ein Magnetfeld zu erzeugen. Die Anordnung weist ferner eine vom Magneten beabstandete Sensoreinheit auf, die dazu ausgebildet ist, in einer Messebene das Magnetfeld des Magneten zu erfassen und daraus ein der Winkelposition des Bauteils entsprechendes Winkelsignal zu liefern.

Dabei sind der Magnet oder die Sensoreinheit um die drehbare Achse drehbar angeordnet, so dass eine relative Drehbewegung zwischen dem Magneten und der Sensoreinheit ermöglicht ist. Die Sensoreinheit umfasst eine in der Messebene angeordnete erste Sensorgruppe, die ein unter einem vorbestimmten Abstand zur Drehachse angeordnetes erstes magnetisch sensitives Element, ein relativ zur Drehachse dem ersten magnetisch sensitiven Element gegenüberliegend angeordnetes zweites magnetisch sensitives Element, das unter dem vorbestimmten Abstand zur Drehachse angeordnet ist, und ein mittig zwischen dem ersten magnetisch sensitiven Element und dem zweiten magnetisch sensitiven Element angeordnetes drittes magnetisch sensitives Element aufweist. Das erste magnetisch sensitive Element, das zweite magnetisch sensitive Element und das dritte magnetisch sensitive Element sind jeweils dazu ausgebildet, das Magnetfeld entlang einer ersten Richtung zu erfassen. Die Sensoreinheit weist ferner eine in der Messebene angeordnete zweite Sensorgruppe auf, die ein unter dem vorbestimmten Abstand zur Drehachse angeordnetes viertes magnetisch sensitives Element, ein relativ zur Drehachse dem vierten magnetisch sensitiven Element gegenüberliegend angeordnetes fünftes magnetisch sensitives Element, das unter dem vorbestimmten Abstand zur Drehachse angeordnet ist, und ein mittig zwischen dem vierten magnetisch sensitiven Element und dem fünften magnetisch sensitiven Element angeordnetes sechstes magnetisch sensitives Element umfasst. Das vierte magnetisch sensitive Element, das fünfte magnetisch sensitive Element und das sechste magnetisch sensitive Element sind jeweils dazu ausgebildet, das Magnetfeld entlang einer zur ersten Richtung unter einem vorbestimmten Winkel verlaufenden zweiten Richtung zu erfassen. Die erste Richtung und die zweite Richtung verlaufen dabei jeweils in der Messebene. Die Sensoreinheit umfasst zudem eine Auswerteeinheit, die mit den magnetisch sensitiven Elementen der ersten Sensorgruppe und den magnetisch sensitiven Elementen der zweiten Sensorgruppe verbunden und dazu ausgebildet ist, das der Winkelposition des Bauteils entsprechende Winkelsignal zu liefern.

Ferner ist es mit der erfindungsgemäßen Anordnung möglich, die Winkelposition des Bauteils über den vollen Winkelmessbereich von 360° zu erfassen, wobei Technologien für zweidimensionale magnetisch empfindliche Sensorelemente zur Messung parallel zur Sensorebene wirkender Magnetfelder verwendet werden.

Die vorliegende Erfindung basiert demzufolge auf dem Gedanken, dass bei einer symmetrischen Anordnung des Magneten und der Sensoreinheit und gleichzeitigen symmetrischen Anordnung der Sensorbaugruppen relativ zur Drehachse das erfasste Magnetfeld in der Messebene, die vorzugsweise im Wesentlichen senkrecht zur Drehachse steht, das von den magnetisch sensitiven Elementen, durch die die Drehachse verläuft, erfasste Magnetfeld betragsmäßig größer ist als das von den unter dem vorbestimmten Abstand zur Drehachse angeordneten magnetisch sensitiven Elementen. Durch die Auswerteeinheit werden die Signale von den unter dem vorbestimmten Abstand zur Drehachse angeordneten magnetisch sensitiven Elementen mit einem unterschiedlichen mathematischen Vorzeichen versehen als die Signale von den angeordneten magnetisch sensitiven Elementen, durch die die Drehachse verläuft. Dabei wird jeweils das Signal des auf der Drehachse angeordneten magnetisch sensitiven Elements jeweils mit den zwei unter dem vorbestimmten Abstand zur Drehachse angeordneten magnetisch sensitiven Element in geeigneter Weise verknüpft und die daraus resultierenden Zwischensignale werden daraufhin von einem Auswerteelement zur Bestimmung eines Komponentensignals verarbeitet.

Aufgrund der Tatsache, dass etwaige magnetische Stör-/Fremdfelder von allen magnetisch sensitiven Elementen einer Sensorgruppe betragsmäßig in einer homogenen Richtung erfasst werden, jedoch das entsprechende Auswertelement die Signale mit unterschiedlichen mathematischen Vorzeichen versieht, kann die Auswerteeinheit letztendlich den negativen Einfluss der magnetischen Stör-/Fremdfelder auf die Messungen der Winkelposition kompensieren bzw. herausfiltern. Somit wird durch die geeignete Anordnung von magnetisch sensitiven Elementen und durch geeignete Auswertung der Signale der magnetisch sensitiven Elemente der Einfluss des magnetischen Stör-/Fremdfelds herausgefiltert und somit zu jedem Zeitpunkt verzögerungsfrei eine störfeldunempfindliche Messgenauigkeit der Sensoreinheit erreicht wird.

In einer vorteilhaften Ausgestaltung umfasst die Auswerteeinheit ein erstes Auswerteelement, das mit dem ersten magnetisch sensitiven Element und dem dritten magnetisch sensitiven Element verbunden und dazu ausgebildet ist, aus den Signalen des ersten magnetisch sensitiven Elements und des dritten magnetisch sensitiven Elements ein erstes Zwischensignal zu erzeugen. Die Auswerteeinheit umfasst zudem ein zweites Auswerteelement, das mit dem zweiten magnetisch sensitiven Element und dem dritten magnetisch sensitiven Element verbunden und dazu ausgebildet ist, aus den Signalen des zweiten magnetisch sensitiven Elements und des dritten magnetisch sensitiven Elements ein zweites Zwischensignal zu erzeugen.

Ferner weist die Auswerteeinheit ein drittes Auswerteelement auf, das mit dem vierten magnetisch sensitiven Element und dem sechsten magnetisch sensitiven Element verbunden und dazu ausgebildet ist, aus den Signalen des vierten magnetisch sensitiven Element und des sechsten magnetisch sensitiven Elements ein drittes Zwischensignal zu erzeugen. Die Auswerteeinheit umfasst zudem ein viertes Auswerteelement, das mit dem fünften magnetisch sensitiven Element und dem sechsten magnetisch sensitiven Element verbunden und dazu ausgebildet ist, aus den Signalen des fünften magnetisch sensitiven Elements und des sechsten magnetisch sensitiven Elements ein viertes Zwischensignal zu erzeugen.

In einer bevorzugten Ausführungsform sind das erste Auswerteelement und/oder das zweite Auswerteelement und/oder das dritte Auswerteelement und/oder das vierte Auswerteelement jeweils ein analoger Differenzbilder, der die beiden Eingangssignale mit unterschiedlichen mathematischen Vorzeichen versieht und deshalb die beiden Signal voneinander subtrahiert.

Die Auswerteeinheit umfasst in einer bevorzugten Ausführungsform ein fünftes Auswerteelement, das mit dem ersten Auswerteelement und dem zweiten Auswerteelement verbunden und dazu ausgebildet ist, aus dem ersten Zwischensignal und dem zweiten Zwischensignal ein erstes Komponentensignal zu erzeugen, das betragsmäßig dem zweifachen Wert der Differenz des von dem magnetisch sensitiven Element, durch das die Drehachse verläuft, erfassten Magnetfelds und der von den beiden unter dem vorbestimmten Abstand zur Drehachse angeordneten magnetisch sensitiven Elementen erfassten Magnetfelder entlang der ersten Richtung entspricht. Ferner weist die Auswerteeinheit ein sechstes Auswerteelement auf, das mit dem dritten Auswerteelement und dem vierten Auswerteelement verbunden und dazu ausgebildet ist, aus dem dritten Zwischensignal und dem vierten Zwischensignal ein zweites Komponentensignal zu erzeugen, das betragsmäßig dem zweifachen Wert von der Differenz des Magnetfelds von dem magnetisch sensitiven Element, durch das die Drehachse verläuft, erfassten Magnetfelds und der von den beiden unter dem vorbestimmten Abstand zur Drehachse angeordneten magnetisch sensitiven Elementen erfassten Magnetfelder entlang der zweiten Richtung entspricht. Zudem weist die Auswerteeinheit ein siebtes Auswerteelement auf, das mit dem fünften Auswerteelement und dem sechsten Auswerteelement verbunden und dazu ausgebildet ist, aus dem ersten Komponentensignal und dem zweiten Komponentensignal das der Winkelposition des Bauteils entsprechende Winkelsignal zu erzeugen. Bevorzugt sind das fünfte Auswerteelement und/oder das sechste Auswerteelement ein analoger Summenbilder, der die beiden Eingangssignale miteinander addiert.

In einer Ausgestaltung der hierin offenbarten Anordnung können mehrere Auswerteelemente in einem Auswerteelement integriert sein. Beispielsweise können das erste, zweite und dritte Auswerteelement in einer ersten Auswerteuntereinheit integriert sein, die die Funktionen des ersten, zweiten und dritten Auswerteelements ausführt und somit das erste Komponentensignal erzeugt. In ähnlicher Weise können das vierte, fünfte und sechste Auswerteelement in einer zweiten Auswerteuntereinheit integriert sein, die die Funktionen des vierten, fünften und sechsten Auswerteelements ausführt und somit das zweite Komponentensignal erzeugt.

In einer weiteren bevorzugten Ausführungsform ist das erste Komponentensignal ein cosinusförmiges Signal bezüglich des vorbestimmten Winkels und das zweite Komponentensignal ein sinusförmiges Signal bezüglich des vorbestimmten Winkels. Das dritte Auswerteelement ist in dieser Ausführungsform dazu ausgebildet, das der Winkelposition des Bauteils entsprechende Winkelsignal mittels einer Arcustangens-Funktion aus dem ersten Komponentensignal und dem zweiten Komponentensignal zu erzeugen.

In einer bevorzugten Ausgestaltung verläuft die erste Richtung (x) im Wesentlichen orthogonal zur zweiten Richtung (y). In einer solchen Ausgestaltung werden vom fünften Auswertelemente das cosinusförmige erste Komponentensignal Sy und vom sechsten Auswerteelement das sinusförmige zweite Komponentensignal Sx geliefert. Folglich kann das siebte Auswertelement mit der Gleichung ϕ = arctan(Sx/Sy) die Winkelposition des um die Drehachse drehbaren Bauteils bestimmen, wobei Sx ∼ sin(ϕ) und Sy ∼ cos(ϕ).

Der Magnet ist vorzugsweise ein zweipoliger Magnet, der dazu ausgebildet ist, ein Magnetfeld zu erzeugen. Bevorzugt ist der Magnet ein quaderförmiger Magnet und ist derart zur Drehachse angeordnet, dass die Drehachse mittig durch den Magneten verläuft und somit die Grenzfläche zwischen den beiden Polen passiert. In weiteren Ausgestaltungen kann der Magnet auch kreiszylinderförmig ausgebildet sein. Der Magnet kann ferner mit einer ganzzahlig durch zwei teilbaren Anzahl von Polen ausgeführt sein.

In einer vorteilhaften Ausgestaltung der Lehren der offenbarten Anordnung ist der Magnet am drehbaren Bauteil befestigt und die Sensoreinheit ist relativ zum Magneten ortsfest angeordnet. Somit kann sich der Magnet mit dem drehbaren Bauteil drehen, wobei die Sensoreinheit diese Drehung erfasst und auf die Winkelposition des drehbaren Bauteils schließen kann.

In einer alternativen Ausführungsform der Anordnung ist der Magnet relativ zur Sensoreinheit ortsfest angeordnet und die Sensoreinheit ist am drehbaren Bauteil befestigt. In einer solchen Ausgestaltung kann sich die Sensoreinheit gemeinsam mit dem drehbaren Bauteil relativ zum Magneten drehen und somit die Winkelposition des Bauteils ermitteln.

Vorzugsweise ist die Sensoreinheit derart zur Drehachse ausgerichtet, dass die Messebene im Wesentlichen orthogonal zur Drehachse verläuft.

In einer weiteren vorteilhaften Ausgestaltung der hierin offenbarten Anordnung ist zumindest eines der magnetisch sensitiven Elemente eine vertikale Hall-Zelle. Ferner kann zumindest eines der magnetisch sensitiven Elemente auf dem magnetoresistiven Effekt (MR) basieren. Beispielsweise besteht ein auf dem magnetoresistiven Effekt beruhendes magnetisch sensitives Element aus einem anisotropen magnetoresistiven (AMR), einem riesen-magnetoresistiven (GMR) oder Tunnel-magnetoresistiven (TMR) Element.

Weitere Merkmale und Ausgestaltungen der erfindungsgemäßen Anordnung werden unter nachfolgender Bezugnahme auf die Zeichnungen ersichtlich. Darin zeigen:
- Fig. 1: eine schematische Ansicht einer erfindungsgemäßen Anordnung zur Erfassung der Winkelposition eines um eine Drehachse drehbaren Bauteils, und
- Fig. 2: eine Draufsicht auf eine Sensoreinheit der Anordnung der Fig. 1.

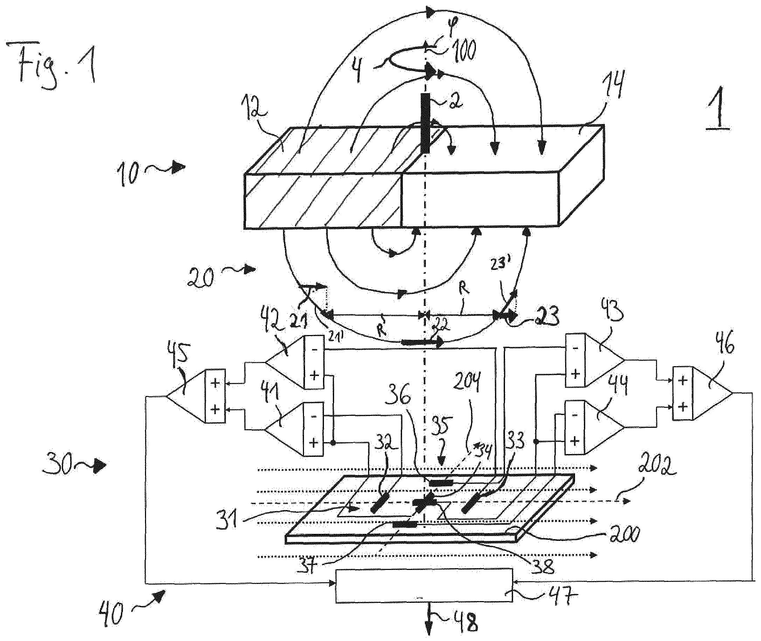

Die Fig. 1 zeigt eine Ausführungsform einer erfindungsgemäßen Anordnung 1 zur Erfassung der Winkelposition ϕ eines um eine Drehachse 100 drehbaren Bauteils 2. Das drehbare Bauteil 2 kann beispielsweise eine Welle eines Rotors eines Gleichstrommotors sein. In weiteren Ausführungsbeispielen der Anordnung 1 kann das drehbare Bauteil 2 eine Drosselklappenwelle eines Drosselklappenstützens einer Brennkraftmaschine oder eines Aktuators zur mechanischen Verstellung sein.

Die Anordnung 1 der Fig. 1 weist einen Magneten 10 auf, der dazu ausgebildet ist, ein Magnetfeld 20 zu erzeugen. In der Fig. 1 sind die Magnetfeldlinien des Magnetfelds 20 schematisch eingezeichnet. Wie in der Fig. 1 dargestellt, weist der Magnet 10 zwei Pole auf, nämlich einen Nordpol 12 und einen Südpol 14. Der Magnet 10 ist derart bezüglich der Drehachse 100 angeordnet, dass die Drehachse 100 mittig durch den Magneten 10, insbesondere durch die Grenzfläche zwischen dem Nordpol 12 und dem Südpol 14, verläuft. Das Bauteil 2 ist zusammen mit dem Magneten 10 um die Drehachse 100 drehbar (siehe eingezeichneten Pfeil 4).

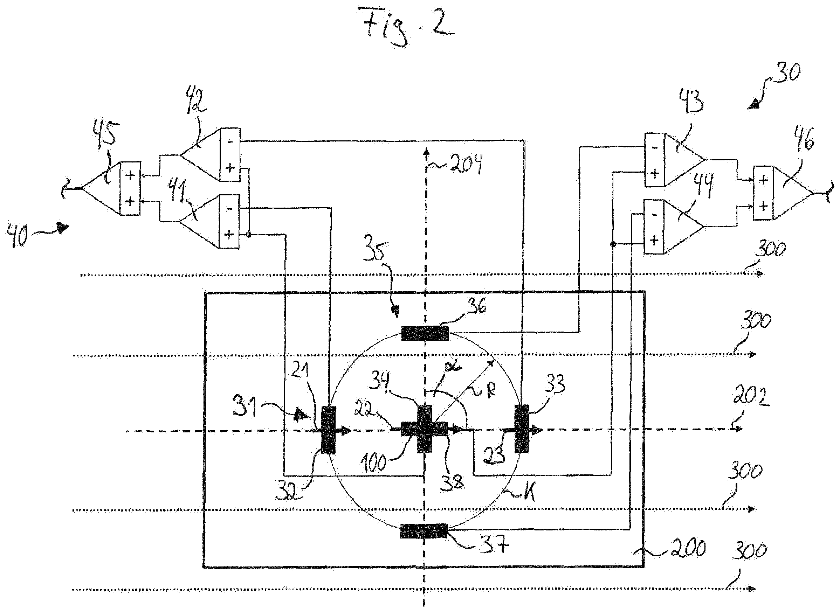

Die in der Fig. 1 dargestellte Anordnung 1 weist ferner eine vom Magneten 10 beabstandete Sensoreinheit 30 auf. Die Sensoreinheit 30 ist vorzugsweise ein Sensorchip und ist in einer Messebene 200, die durch eine erste Achse 202, beispielsweise eine x-Achse, und eine orthogonal zu dieser verlaufenden zweiten Achse 204, beispielsweise eine y-Achse, aufgespannt wird, magnetisch sensitiv. Folglich beträgt der vorbestimmte Winkel α zwischen der ersten Achse 202 und der zweiten Achse 204 in der gezeigten Ausführungsform 90° (siehe Fig. 2). Die beiden Achsen 202, 204 sind jeweils orthogonal zur Drehachse 100 angeordnet, so dass folglich die Messebene 200 der Sensoreinheit 30 im Wesentlichen orthogonal zur Drehachse 100 verläuft.

Die Sensoreinheit 30 ist dazu ausgebildet, auf Magnetfeldkomponenten magnetisch sensitiv zu sein, die in der Messebene 200 verlaufen. Die Sensoreinheit 30 ist ferner dazu ausgebildet, auf Magnetfeldkomponenten nicht magnetisch sensitiv zu sein, die orthogonal zur Messebene 200 verlaufen, folglich also nicht in der Messebene 200 liegen.

Die Sensoreinheit 30 ist in der in der Fig. 1 dargestellten Anordnung 100 ortsfest angeordnet und dazu ausgebildet, das Magnetfeld 20 des Magneten 10 zu erfassen und daraus ein der Winkelposition ϕ des Bauteils 2 entsprechendes Winkelsignal 48 zu liefern.

Unter zusätzlichen Verweis auf die Fig. 2 weist die Sensoreinheit 30 hierzu eine in der Messebene 200 angeordnete erste Sensorgruppe 31 auf, die ein unter einem vorbestimmten Abstand R zur Drehachse 100 angeordnetes erstes magnetisch sensitives Element 32, ein relativ zur Drehachse 100 dem ersten magnetisch sensitiven Element 32 gegenüberliegend angeordnetes zweites magnetisch sensitives Element 33, das ebenfalls unter dem vorbestimmten Abstand R zur Drehachse 100 angeordnet ist, und ein mittig zwischen dem ersten magnetisch sensitiven Element 32 und dem zweiten magnetisch sensitiven Element 33 angeordnetes drittes magnetisch sensitives Element 34 umfasst, durch das somit die Drehachse 100 verläuft. Das erste magnetisch sensitive Element 32, das zweite magnetisch sensitive Element 33 und das dritte magnetisch sensitive Element sind jeweils dazu ausgebildet, diejenigen Magnetfeldkomponenten des Magnetfelds 20 zu erfassen, die in Richtung der ersten Achse 202 verlaufen.

Die Sensoreinheit 30 weist ferner eine in der Messebene 200 zweite Sensorgruppe 35 auf, die ein unter dem vorbestimmten Abstand R zur Drehachse 100 angeordnetes viertes magnetisch sensitives Element 36, ein relativ zur Drehachse 100 dem vierten magnetisch sensitiven Element 36 gegenüberliegend angeordnetes fünftes magnetisch sensitives Element 37, das unter dem vorbestimmten Abstand R zur Drehachse 100 angeordnet ist, und ein mittig zwischen dem vierten magnetisch sensitiven Element 32 und dem fünften magnetisch sensitiven Element 33 angeordnetes sechstes magnetisch sensitives Element 38 umfasst, durch das somit die Drehachse 100 verläuft. Das vierte magnetisch sensitive Element 36, das fünfte magnetisch sensitive Element 37 und das sechste magnetisch sensitive Element 38 sind jeweils dazu ausgebildet, diejenigen Magnetfeldkomponenten des Magnetfelds 20 zu erfassen, die in Richtung der zweiten Achse 204 verlaufen.

Wie der Fig. 2 zu entnehmen ist, sind das erste magnetisch sensitive Element 32, das zweite magnetisch sensitive Element 33, das vierte magnetisch sensitive Element 36 und das fünfte magnetisch sensitive Element 37 kreisförmig auf einem Kreis K mit Radius R angeordnet, der in der Messebene 200 angeordnet ist und dessen Mittelpunkt auf der Drehachse 100 liegt. Das dritte magnetisch sensitive Element 34 und das sechsten magentisch sensitive Element 38 sind auf dem Mittelpunkt des Kreises K angeordnet und um den Winkel α zueinander gedreht.

Die Sensoreinheit 30 umfasst ferner eine Auswerteeinheit 40, die mit den magnetisch sensitiven Elementen 32, 33, 34 der ersten Sensorgruppe 31 und mit den magnetisch sensitiven Elementen 36, 37, 38 der zweiten Sensorgruppe 35 verbunden und dazu ausgebildet ist, das der Winkelposition ϕ des Bauteils 2 entsprechende Winkelsignal 48 zu liefern. Die Verbindung der Auswerteeinheit 40 mit den magnetisch sensitiven Elementen 32, 33, 34, 36, 37, 38 der jeweils ersten und zweiten Sensorgruppe 31, 35 können mittels geeigneter Verbindungsleitungen, beispielsweise Drähte (in der Fig. 1 mit durchgezogenen Linien dargestellt) realisiert sein. In weiteren Ausgestaltungen der Anordnung 1 können die Verbindungen der Auswerteeinheit 40 mit magnetisch sensitiven Elementen 32, 33, 34, 36, 37, 38 der jeweils ersten und der zweiten Sensorgruppe 31, 35 auch drahtlos realisiert sein, beispielsweise einer geeigneten Funkverbindung.

In weiteren Ausgestaltungen können zwischen den magnetisch sensitiven Elementen und Auswerteelementen weitere Auswerteschaltungen eingesetzt sein, um Quereinflüsse wie Temperaturabhängigkeiten und mechanische Streßempfindlichkeiten zu unterdrücken. Beispielsweise können zwischen den magnetisch sensitiven Elementen und Auswerteelementen Modulations- und Demodulationsschaltungen angeordnet sein.

Ferner können die magnetisch sensitiven Elemente aus mehreren Einzelelementen, wie beispielsweise Hall-Zellen und/oder 2- oder 4-fach Brückenschaltungen von einzelnen magnetoresitiven Einzelwiderständen, aufgebaut sein. Außerdem können die Auswerteelemente weitere Auswerteschaltungen beinhalten.

Die Auswerteeinheit 40 weist ein erstes Auswerteelement 41 auf, das mit dem ersten magnetisch sensitiven Element 32 und dem dritten magnetisch sensitiven Element 34 verbunden und dazu ausgebildet ist, aus den Signalen des ersten magnetisch sensitiven Elements 32 und des dritten magnetisch sensitiven Elements 34 ein erstes Zwischensignal zu erzeugen. Die Auswerteeinheit 40 umfasst ferner ein zweites Auswerteelement 42, das mit dem zweiten magnetisch sensitiven Element 33 und dem dritten magnetisch sensitiven Element 34 verbunden und dazu ausgebildet ist, aus den Signalen des zweiten magnetisch sensitiven Elements 33 und des dritten magnetisch sensitiven Elements 34 ein zweites Zwischensignal zu erzeugen.

Die Auswerteeinheit 40 umfasst zudem ein drittes Auswerteelement 43, das mit dem vierten magnetisch sensitiven Element 36 und dem sechsten magnetisch sensitiven Element 38 verbunden und dazu ausgebildet ist, aus den Signalen des vierten magnetisch sensitiven Elements 36 und des sechsten magnetisch sensitiven Elements 38 ein drittes Zwischensignal zu erzeugen. Die Auswerteeinheit 40 umfasst ferner ein viertes Auswerteelement 44, das mit dem fünften magnetisch sensitiven Elements 37 und dem sechsten magnetisch sensitiven Element 38 verbunden und dazu ausgebildet ist, aus den Signalen des fünften magnetisch sensitiven Elements 37 und des sechsten magnetisch sensitiven Elements 38 ein viertes Zwischensignal zu erzeugen.

In der in den Fig. 1 und 2 dargestellten Ausführungsform sind die Zwischensignale der Auswertelemente 41, 42, 43, 44 jeweils Differenzsignale, die die Differenz der jeweiligen Signale der magnetisch sensitiven Elemente darstellen.

Zur Weiterverarbeitung der mehreren Zwischensignale (bzw. Differenzsignale) umfasst die Auswerteeinheit 40 ein fünftes Auswerteelement 42 und ein sechstes Auswerteelement 46. Das fünfte Auswerteelement 45 ist mit dem ersten Auswerteelement 41 und dem zweiten Auswerteelement 42 verbunden und dazu ausgebildet, aus dem ersten Zwischensignal und dem zweiten Zwischensignal ein erstes Komponentensignal zu erzeugen, das dem zweifachen Wert der Differenz des von dem dritten magnetisch sensitiven Element 34 erfassten Magnetfelds 20 und jeweils dem von dem ersten bzw. zweiten magnetisch sensitiven Elements 32, 33 erfassten Magnetfelds 20 entlang der ersten Achse 202 entspricht. Das sechste Auswerteelement 46 ist mit dem dritten Auswerteelement 43 und dem vierten Auswerteelement 44 verbunden und dazu ausgebildet, aus dem dritten Zwischensignal und dem vierten Zwischensignal ein zweites Komponentensignal zu erzeugen, das dem zweifachen Wert der Differenz des von dem sechsten magnetisch sensitiven Element 38 erfassten Magnetfelds 20 und jeweils dem von dem vierten bzw. fünften magnetisch sensitiven Elements 36, 37 erfassten Magnetfelds 20 entlang der ersten Achse 202 entspricht .

Die Auswerteeinheit 40 umfasst ferner ein siebtes Auswerteelement 47, das mit dem fünften Auswerteelement 45 und dem sechsten Auswerteelement 46 verbunden und dazu ausgebildet ist, aus dem ersten Komponentensignal und dem zweiten Komponentensignal das der Winkelposition ϕ des Bauteils 2 entsprechende Winkelsignal 48 zu erzeugen.

In einer bevorzugten Ausführungsform, wie in den Fig. 1 und 2 gezeigt, sind das fünfte Auswerteelement 45 und/oder das sechste Auswerteelement 46 ein analoger Summenbilder, der jeweils die beiden Eingangssignale addiert. Zudem sind bevorzugt das erste Auswerteelement 41, das zweite Auswerteelement 42, das dritte Auswerteelement 43 und/oder das vierte Auswerteelement 44 ein analoger Differenzbilder, der die beiden Signale der magnetisch sensitiven Elemente subtrahiert.

Wie in den Fig. 1 und 2 angedeutet und wie bereits oben erläutert, sind das erste Auswerteelement 41, das zweite Auswerteelement 42, das dritte Auswerteelement 43 und das vierte Auswerteelement 44 jeweils Differenzbilder, die jeweils den eingehenden Signalen der beiden entsprechenden magnetisch sensitiven Elementen unterschiedliche mathematische Vorzeichen zuordnet und somit die Differenz bildet. Die Differenzbilder können jeweils analog oder digital sein.

In den Fig. 1 und 2 sind beispielhaft Magnetfeldkomponenten 21', 22, 23' dargestellt, die jeweils den Komponenten entlang der ersten Achse 202 entsprechen. Die auf die Messsebene 200 beispielhaft projizierten Magnetfeldkomponenten 21', 22, 23' stammen jeweils vom Magnetfeld 20 und werden von den magnetisch sensitiven Elementen 32, 33, 34 der ersten Sensorgruppe 31 und den magnetisch sensitiven Elementen 36, 37, 38 der zweiten Sensorgruppe 35 erfasst, wobei die Magnetfeldkomponenten 21, 22, 23 entlang der zweiten Achse 204 in der gezeigten Position keinen Betrag aufweisen und folglich die magnetisch sensitiven Elementen 36, 37, 38 der zweiten Sensorgruppe 35 jeweils keine Signale liefern. Die Magnetfeldkomponenten 21', 22, 23' stellen Vektoren dar und sind betragsmäßig gleich groß, d. h. die Länge dieser Vektoren ist gleich lang, jedoch die jeweilige Ausrichtung unterschiedlich. In der Fig. 1 sind mit den gepunkteten Linien an den Magnetfeldkomponenten 21' und 23' schematisch die Komponenten parallel zur Drehachse 100 (Vektorzerlegung) angedeutet. Die Magnetfeldkomponenten 21 und 23 stellen die Komponenten parallel zur ersten Achse 202 dar.

Unter zusätzlichem Verweis auf die Fig. 1 ist die Magnetfeldkomponente 22 eine Komponente, die zur Drehachse 100 im Wesentlichen orthogonal verläuft und somit im Wesentlichen parallel zur Messebene 200 ist. Folglich weist die Komponente 22 lediglich eine Komponente in der Messebene 200 (nämlich parallel zur ersten Achse 202), jedoch keine Komponenten parallel zur Drehachse 100 bzw. parallel zur zweiten Achse 204 auf.

Unter dem Abstand R von der Drehachse 100 beabstandet sind die parallel zur ersten Achse 202 verlaufenden Magnetfeldkomponenten 21 und 22 exemplarisch eingezeichnet (siehe Fig. 1), Aufgrund des gekrümmten Magnetfelds 200 sind die in der Messebene 200 von den magnetisch sensitiven Elementen 32 und 33 erfassten projizierten Magnetfeldkomponenten 21, 23 betragsmäßig kleiner als die von dem magnetisch sensitiven Element 34 erfasste Magnetfeldkomponente 22.

Das erste Auswerteelement 41 ist in der Form eines Differenzbilders ausgestaltet und ordnet den Signalen des ersten magnetisch sensitiven Elements 32 und des dritten magnetisch sensitiven Elements 34 unterschiedliche mathematische Vorzeichen zu. In gleicher Weise ordnet das in Form eines Differenzbilders ausgestaltete zweite Auswerteelement 42 den Signalen des zweiten magnetisch sensitiven Elements 33 und des dritten magnetisch sensitiven Elements 34 unterschiedliche mathematische Vorzeichen zu. Das fünfte Auswerteelement 45 addiert die Differenzsignale des ersten Auswerteelements 42 und des zweiten Auswerteelements 42 und erzeugt daraus ein cosinusförmiges erstes Komponentensignal bezüglich des vorbestimmten Winkels α.

Aus Symmetriegründen und zur Erzielung eines doppelten Nutzsignales werden zwei Differenzsignale gebildet, die anschließend addiert werden. Wenn sich beispielsweise die Drehachse 10 etwas vom Mittelpunkt des Kreises K in Richtung der Achse 202 verschiebt, wird das Differenzsignal 42 schwächer und das zweite komplementäre Differenzsignal 41 stärker. Damit bleibt im Wesentlichen das erzeugte Summensignal nach dem Auswerteelement 45 unverändert und die Winkelposition ϕ es Bauteils 2 kann weiterhin störfeldbereinig ermittelt werden.

In ähnlicher Weise werten das dritte Auswerteelement 43 und das vierte Auswerteelement 44 die von den entlang der zweiten Achse 204 angeordneten magnetisch sensitiven Elementen 36, 37, 38 der zweiten Sensorgruppe 35 erzeugten Signale aus, so dass das sechste Auswerteelement 46 daraus ein sinusförmiges zweites Komponentensignal bezüglich des vorbestimmten Winkels α erzeugt.

Unter Kenntnis des Winkels α zwischen der ersten Achse 202 und der zweite Achse 204 kann daraufhin das dritte Auswerteelement 46 das der Winkelposition ϕ des Bauteils 2 entsprechende Winkelsignal 47 liefern. Insbesondere ist das siebte Auswerteelement 47 dazu ausgebildet, die Komponentensignale des fünften und sechsten Auswerteelements 45, 46 zu verarbeiten und mittels einer Arcustangens-Funktion derart auszuwerten, dass die Winkelposition ϕ des drehbaren Bauteils 2 ermittelt werden kann. Somit wird bei einer Vollkreisdrehung des Bauteils 2 das so erzeugte Winkelsignal 48 eindeutig abgebildet und der Messbereich beträgt 0° bis 360°.

In den Fig. 1 und 2 ist beispielhaft ein parallel zur Messebene 200 verlaufendes magnetisches Stör-/Fremdfeld 300 eingezeichnet, das im Wesentlichen in positiver Richtung parallel zur ersten Achse 202 verläuft. Das magnetische Stör-/Fremdfeld 300 erhöht somit betragsmäßig die von den magnetisch sensitiven Elementen 32, 33, 34 erfassten Magnetfeldkomponenten 21, 22, 23, so dass die Eingangssignale in die Auswerteelemente 41, 42 durch das magnetische Stör-/Fremdfeld 300 jeweils angehoben sind. Aus der Tatsache, dass die Auswerteelemente 41, 42 in der dargestellten Ausführungsform als Differenzbilder ausgestaltet sind, die jeweils die Signale der magnetisch sensitiven Elemente 32, 33 von dem Signal des magnetisch sensitiven Elements 34 abzieht, wird jeweils der Einfluss des Störfelds 300 herausgefiltert bzw. kompensiert. Folglich sind die beiden Differenzsignale der Auswerteelemente 41, 42 jeweils störfeldbereinigt und können somit von dem fünften Auswerteelement 45 zu dem ersten Komponentensignal weiterverarbeitet werden.

In ähnlicher Weise erfolgt die Störfeldbereinigung in den Auswerteelementen 43, 44, so dass auch das zweite Komponentensignal des sechsten Auswerteelements 46 durch das magnetische Stör-/Fremdfeld 300 nicht verfälscht ist.

Zusammenfassend ist es mit der Anordnung 1 gemäß den Fig. 1 und 2 möglich, durch geeignete Auswertung der Signale der magnetisch sensitiven Elemente 32, 33, 34, 36, 37, 38 vorhandene externe magnetische Stör-/Fremdfelder 300 zu kompensieren und somit die Messgenauigkeit der Sensoreinheit 30 zu erhöhen.

Mit der erfindungsgemäßen Anordnung 1 ist es also möglich, zuverlässig die Winkelposition ϕ des drehbaren Bauteils 2 in einem Winkelbereich von 360° eindeutig und nahezu in Echtzeit zu erfassen. Insbesondere ist dies bei bürstenlosen Gleichstrommotoren vorteilhaft, da die Anordnung 1 die Winkelposition ϕ des Rotors zu jedem Zeitpunkt verzögerungsfrei, möglichst genau und ungestört von magnetischen Stör-/Fremdfeldern erfassen kann.

## Patentansprüche

1. Anordnung (1) zur Erfassung der Winkelposition (ϕ) eines um eine Drehachse (100) drehbaren Bauteils (2), mit:
- einem Magneten (10), der dazu ausgebildet ist, ein Magnetfeld (20) zu erzeugen, und
- einer vom Magneten (10) beabstandeten Sensoreinheit (30), die dazu ausgebildet ist, das Magnetfeld (20) in einer im Wesentlichen orthogonal zur Drehachse (100) verlaufenden Messebene (200) zu erfassen und daraus ein der Winkelposition (ϕ) des Bauteils (2) entsprechendes Winkelsignal (48) zu liefern, wobei der Magnet (10) oder die Sensoreinheit (30) um die Drehachse (100) drehbar angeordnet sind, wobei die Sensoreinheit (30) aufweist:
- eine in der Messebene (200) angeordnete erste Sensorgruppe (31), die ein unter einem vorbestimmten Abstand (R) zur Drehachse (100) angeordnetes erstes magnetisch sensitives Element (32), ein relativ zur Drehachse (100) dem ersten magnetisch sensitiven Element (32) gegenüberliegend angeordnetes zweites magnetisch sensitives Element (33), das unter dem vorbestimmten Abstand zur Drehachse (100) angeordnet ist, und ein mittig zwischen dem ersten magnetisch sensitiven Element (32) und dem zweiten magnetisch sensitiven Element (33) angeordnetes drittes magnetisch sensitives Element (34) umfasst, wobei das erste magnetisch sensitive Element (32), das zweite magnetisch sensitive Element (33) und das dritte magnetisch sensitive Element (34) jeweils dazu ausgebildet sind, das Magnetfeld (20) entlang einer ersten Richtung (202) zu erfassen,
- eine in der Messebene (200) angeordnete zweite Sensorgruppe (35), die ein unter dem vorbestimmten Abstand (R) zur Drehachse (100) angeordnetes viertes magnetisch sensitives Element (36), ein relativ zur Drehachse (100) dem vierten magnetisch sensitiven Element (36) gegenüberliegend angeordnetes fünftes magnetisch sensitives Element (37), das unter dem vorbestimmten Abstand zur Drehachse (100) angeordnet ist, und ein mittig zwischen dem vierten magnetisch sensitiven Element (36) und dem fünften magnetisch sensitiven Element (37) angeordnetes sechstes magnetisch sensitives Element (38) umfasst, wobei das vierte magnetisch sensitive Element (36), das fünfte magnetisch sensitive Element (37) und das sechste magnetisch sensitive Element (38) jeweils dazu ausgebildet sind, das Magnetfeld (20) entlang einer zur ersten Richtung (202) um einen vorbestimmten Winkel (α) verlaufenden zweiten Richtung (204) zu erfassen, und
- eine Auswerteeinheit (40), die mit den magnetisch sensitiven Elementen (32, 33, 34) der ersten Sensorgruppe (31) und den magnetisch sensitiven Elementen (36, 37, 38) der zweiten Sensorgruppe (35) verbunden und dazu ausgebildet ist, das der Winkelposition (ϕ) des Bauteils (2) entsprechende Winkelsignal (48) zu liefern.

2. Anordnung (1) nach Anspruch 1, wobei die Auswerteeinheit (40) umfasst:
ein erstes Auswerteelement (41), das mit dem ersten magnetisch sensitiven Element (32) und dem dritten magnetisch sensitiven Element (34) verbunden und dazu ausgebildet ist, aus den Signalen des ersten magnetisch sensitiven Elements (32) und des dritten magnetisch sensitiven Elements (34) ein erstes Zwischensignal zu erzeugen,
ein zweites Auswerteelement (42), das mit dem zweiten magnetisch sensitiven Element (33) und dem dritten magnetisch sensitiven Element (34) verbunden und dazu ausgebildet ist, aus den Signalen des zweiten magnetisch sensitiven Elements (33) und des dritten magnetisch sensitiven Elements (34) ein zweites Zwischensignal zu erzeugen,
ein drittes Auswerteelement (43), das mit dem vierten magnetisch sensitiven Element (36) und dem sechsten magnetisch sensitiven Element (38) verbunden und dazu ausgebildet ist, aus den Signalen des vierten magnetisch sensitiven Elements (36) und des sechsten magnetisch sensitiven Elements (38) ein drittes Zwischensignal zu erzeugen, und
ein viertes Auswerteelement (44), das mit dem fünften magnetisch sensitiven Element (37) und dem sechsten magnetisch sensitiven Element (38) verbunden und dazu ausgebildet ist, aus den Signalen des fünften magnetisch sensitiven Elements (37) und des sechsten magnetisch sensitiven Elements (38) ein viertes Zwischensignal zu erzeugen.

3. Anordnung (1) nach Anspruch 2, wobei die Auswerteeinheit (40) ferner umfasst:
ein fünftes Auswerteelement (45), das mit dem ersten Auswerteelement (41) und dem zweiten Auswerteelement (42) verbunden und dazu ausgebildet ist, aus dem ersten Zwischensignal und dem zweiten Zwischensignal ein erstes Komponentensignal zu erzeugen,
ein sechstes Auswerteelement (46), das mit dem dritten Auswerteelement (43) und dem vierten Auswerteelement (44) verbunden und dazu ausgebildet ist, aus dem dritten Zwischensignal und dem vierten Zwischensignal ein zweites Komponentensignal zu erzeugen, und
ein siebtes Auswerteelement (47), das mit dem fünften Auswerteelement (45) und dem sechsten Auswerteelement (46) verbunden und dazu ausgebildet ist, aus dem ersten Komponentensignal und dem zweiten Komponentensignal das der Winkelposition (ϕ) des Bauteils (2) entsprechende Winkelsignal (48) zu erzeugen.

4. Anordnung (1) nach Anspruch 3, wobei das fünfte Auswerteelement (45) und/oder das sechste Auswerteelement (46) ein Additionsbilder sind.

5. Anordnung (1) nach einem der Ansprüche 2 bis 4, wobei das erste Auswerteelement (41) und/oder das zweite Auswerteelement (42) und/oder das dritte Auswerteelement (43) und/oder das vierte Auswerteelement (44) ein Differenzbilder sind.

6. Anordnung (1) nach einem der Ansprüche 3 bis 5, wobei
das erste Komponentensignal ein conisusförmiges Signal bezüglich des vorbestimmten Winkels (α) ist,
das zweite Komponentensignal ein sinusförmiges Signal bezüglich des vorbestimmten Winkels (α) ist und
das siebte Auswerteelement (47) dazu ausgebildet ist, das der Winkelposition (ϕ) des Bauteils (2) entsprechende Winkelsignal (48) mittels einer Arcustangens-Funktion aus dem ersten Komponentensignal und dem zweiten Komponentensignal zu erzeugen.

7. Anordnung (1) nach einem der vorhergehenden Ansprüche, wobei die Anzahl der Pole des Magneten (10) ganzzahlig durch zwei teilbar ist.

8. Anordnung (1) nach einem der vorhergehenden Ansprüche, wobei der Magnet (10) am drehbaren Bauteil (2) befestigt ist und die Sensoreinheit (30) relativ zum Magneten (10) ortsfest angeordnet ist.

9. Anordnung (1) nach einem der Ansprüche 1 bis 7, wobei der Magnet (10) relativ zur Sensoreinheit (30) ortsfest angeordnet ist und die Sensoreinheit (30) am drehbaren Bauteil (2) befestigt ist.

10. Anordnung (1) nach einem der vorhergehenden Ansprüche, wobei die Messebene (200) im Wesentlichen orthogonal zur Drehachse (100) verläuft.

## Claims

1. Arrangement (1) for capturing the angular position (ϕ) of a component (2) that is rotatable about an axis of rotation (100), comprising:
- a magnet (10), which is embodied to produce a magnetic field (20), and
- a sensor unit (30), which is spaced apart from the magnet (10) and embodied to capture the magnetic field (20) in a measuring plane (200) that extends substantially orthogonal to the axis of rotation (100) and used to supply an angle signal (48) that corresponds to the angular position (ϕ) of the component (2) therefrom, wherein the magnet (10) or the sensor unit (30) is arranged to be rotatable about the axis of rotation (100), wherein the sensor unit (30) has:
- a first sensor group (31) that is arranged in the measuring plane (200), said sensor group comprising a first magnetically sensitive element (32) that is arranged at a predetermined distance (R) from the axis of rotation (100), a second magnetically sensitive element (33) that is arranged opposite to the first magnetically sensitive element (32) relative to the axis of rotation (100), said second magnetically sensitive element being arranged at the predetermined distance from the axis of rotation (100), and a third magnetically sensitive element (34) that is arranged centrally between the first magnetically sensitive element (32) and the second magnetically sensitive element (33), wherein the first magnetically sensitive element (32), the second magnetically sensitive element (33) and the third magnetically sensitive element (34) are each embodied to capture the magnetic field (20) along a first direction (202),
- a second sensor group (35) that is arranged in the measuring plane (200), said sensor group comprising a fourth magnetically sensitive element (36) that is arranged at the predetermined distance (R) from the axis of rotation (100), a fifth magnetically sensitive element (37) that is arranged opposite to the fourth magnetically sensitive element (36) relative to the axis of rotation (100), said fifth magnetically sensitive element being arranged at the predetermined distance from the axis of rotation (100), and a sixth magnetically sensitive element (38) that is arranged centrally between the fourth magnetically sensitive element (36) and the fifth magnetically sensitive element (37), wherein the fourth magnetically sensitive element (36), the fifth magnetically sensitive element (37) and the sixth magnetically sensitive element (38) are each embodied to capture the magnetic field (20) along a second direction (204) that extends at a predetermined angle (α) with respect to the first direction (202), and
- an evaluation unit (40), which is connected to the magnetically sensitive elements (32, 33, 34) of the first sensor group (31) and to the magnetically sensitive elements (36, 37, 38) of the second sensor group (35) and embodied to supply the angle signal (48) corresponding to the angular position (ϕ) of the component (2).

2. Arrangement (1) according to Claim 1, wherein the evaluation unit (40) comprises:
a first evaluation element (41), which is connected to the first magnetically sensitive element (32) and the third magnetically sensitive element (34) and embodied to produce a first intermediate signal from the signals of the first magnetically sensitive element (32) and of the third magnetically sensitive element (34),
a second evaluation element (42), which is connected to the second magnetically sensitive element (33) and the third magnetically sensitive element (34) and embodied to produce a second intermediate signal from the signals of the second magnetically sensitive element (33) and of the third magnetically sensitive element (34),
a third evaluation element (43), which is connected to the fourth magnetically sensitive element (36) and the sixth magnetically sensitive element (38) and embodied to produce a third intermediate signal from the signals of the fourth magnetically sensitive element (36) and of the sixth magnetically sensitive element (38), and
a fourth evaluation element (44), which is connected to the fifth magnetically sensitive element (37) and the sixth magnetically sensitive element (38) and embodied to produce a fourth intermediate signal from the signals of the fifth magnetically sensitive element (37) and of the sixth magnetically sensitive element (38).

3. Arrangement (1) according to Claim 2, wherein the evaluation unit (40) further comprises:
a fifth evaluation element (45), which is connected to the first evaluation element (41) and the second evaluation element (42) and embodied to produce a first component signal from the first intermediate signal and the second intermediate signal,
a sixth evaluation element (46), which is connected to the third evaluation element (43) and the fourth evaluation element (44) and embodied to produce a second component signal from the third intermediate signal and the fourth intermediate signal, and
a seventh evaluation element (47), which is connected to the fifth evaluation element (45) and the sixth evaluation element (46) and embodied to produce the angle signal (48) corresponding to the angular position (ϕ) of the component (2) from the first component signal and the second component signal.

4. Arrangement (1) according to Claim 3, wherein the fifth evaluation element (45) and/or the sixth evaluation element (46) are an addition forming unit.

5. Arrangement (1) according to any one of Claims 2 to 4, wherein the first evaluation element (41) and/or the second evaluation element (42) and/or the third evaluation element (43) and/or the fourth evaluation element (44) are a difference forming unit.

6. Arrangement (1) according to any one of Claims 3 to 5, wherein
the first component signal is a cosine-shaped signal with respect to the predetermined angle (α),
the second component signal is a sine-shaped signal with respect to the predetermined angle (α) and
the seventh evaluation element (47) is embodied to produce the angle signal (48) corresponding to the angular position (ϕ) of the component (2) by means of an arctangent function from the first component signal and the second component signal.

7. Arrangement (1) according to any one of the preceding claims, wherein the number of poles of the magnet (10) is divisible by two as an integer.

8. Arrangement (1) according to any one of the preceding claims, wherein the magnet (10) is fastened to the rotatable component (2) and the sensor unit (30) has a stationary arrangement relative to the magnet (10).

9. Arrangement (1) according to any one of Claims 1 to 7, wherein the magnet (10) has a stationary arrangement relative to the sensor unit (30) and the sensor unit (30) is fastened to the rotatable component (2).

10. Arrangement (1) according to any one of the preceding claims, wherein the measuring plane (200) extends substantially orthogonal to the axis of rotation (100).

## Revendications

1. Dispositif (1) pour détecter la position angulaire (ϕ) d'une pièce (2) qui est rotative autour d'un axe de rotation (100), comportant :
- un aimant (10), qui est conçu pour générer un champ magnétique (20), et
- une unité de capteur (30) espacée de l'aimant (10), qui est conçue pour détecter le champ magnétique (20) dans un plan de mesure (200) sensiblement orthogonal à l'axe de rotation (100) et pour délivrer, à partir de celui-ci, un signal angulaire (48) correspondant à la position angulaire (ϕ) de la pièce (2), dans lequel l'aimant (10) ou l'unité de capteur (30) sont disposés de manière rotative autour de l'axe de rotation (100), dans lequel l'unité de capteur (30) comprend :
- un premier groupe de capteurs (31) disposé dans le plan de mesure (200), qui comprend un premier élément (32) magnétiquement sensible disposé à une distance prédéterminée (R) de l'axe de rotation (100), un deuxième élément (33) magnétiquement sensible disposé en face du premier élément magnétiquement sensible (32) par rapport à l'axe de rotation (100), qui est disposé à la distance prédéterminée de l'axe de rotation (100), et un troisième élément (34) magnétiquement sensible disposé au centre entre le premier élément (32) magnétiquement sensible et le deuxième élément (33) magnétiquement sensible, dans lequel le premier élément (32) magnétiquement sensible, le deuxième élément (33) magnétiquement sensible et le troisième élément (34) magnétiquement sensible sont respectivement conçus pour détecter le champ magnétique (20) dans une première direction (202),
- un deuxième groupe de capteurs (35) disposé dans le plan de mesure (200), qui comprend un quatrième élément (36) magnétiquement sensible disposé à la distance prédéterminée (R) de l'axe de rotation (100), un cinquième élément (37) magnétiquement sensible disposé en face du quatrième élément (36) magnétiquement sensible par rapport à l'axe de rotation (100), qui est disposé à la distance prédéterminée par rapport à l'axe de rotation (100), et qui comprend un sixième élément (38) magnétiquement sensible disposé au centre entre le quatrième élément (36) magnétiquement sensible et le cinquième élément (37) magnétiquement sensible, dans lequel le quatrième élément (36) magnétiquement sensible, le cinquième élément (37) magnétiquement sensible et le sixième élément (38) magnétiquement sensible sont respectivement conçus pour détecter le champ magnétique (20) dans une deuxième direction (204) formant un angle prédéterminé (α) par rapport à la première direction (202),
- une unité d'évaluation (40), qui est reliée aux éléments (32, 33, 34) magnétiquement sensibles du premier groupe de capteurs (31) et aux éléments (36, 37, 38) magnétiquement sensibles du deuxième groupe de capteurs (35) et qui est conçue pour délivrer le signal angulaire (48) correspondant à la position angulaire (ϕ) de la pièce (2).

2. Dispositif (1) selon la revendication 1, dans lequel l'unité d'évaluation comprend (40) :
un premier élément d'évaluation (41), qui est relié au premier élément (32) magnétiquement sensible et au troisième élément (34) magnétiquement sensible et qui est conçu pour générer un premier signal intermédiaire à partir des signaux du premier élément (32) magnétiquement sensible et du troisième élément magnétique sensible (34),
un deuxième élément d'évaluation (42), qui est relié au deuxième élément (33) magnétiquement sensible et au troisième élément (34) magnétiquement sensible et qui est conçu pour générer un deuxième signal intermédiaire à partir des signaux du deuxième élément (33) magnétiquement sensible et du troisième élément (34) magnétiquement sensible,
un troisième élément d'évaluation (43), qui est relié au quatrième élément (36) magnétiquement sensible et au sixième élément (38) magnétiquement sensible et qui est conçu pour générer un troisième signal intermédiaire à partir des signaux du quatrième élément (36) magnétiquement sensible et du sixième élément (38) magnétiquement sensible, et
un quatrième élément d'évaluation (44), qui est relié au cinquième élément (37) magnétiquement sensible et au sixième élément (38) magnétiquement sensible et qui est conçu pour générer un quatrième signal intermédiaire à partir des signaux du cinquième élément (37) magnétiquement sensible et du sixième élément (38) magnétiquement sensible.

3. Dispositif (1) selon la revendication 2, dans lequel l'unité d'évaluation (40) comprend en outre :
un cinquième élément d'évaluation (45), qui est relié au premier élément d'évaluation (41) et au deuxième élément d'évaluation (42) et qui est conçu pour générer un premier signal de composante à partir du premier signal intermédiaire et du deuxième signal intermédiaire,
un sixième élément d'évaluation (46), qui est relié au troisième élément d'évaluation (43) et au quatrième élément d'évaluation (44) et qui est conçu pour générer un deuxième signal de composante à partir du troisième signal intermédiaire et du quatrième signal intermédiaire, et
un septième élément d'évaluation (47), qui est relié au cinquième élément d'évaluation (45) et au sixième élément d'évaluation (46) et qui est conçu pour générer le signal angulaire (48) correspondant à la position angulaire (ϕ) de la pièce (2) à partir du premier signal de composante et du deuxième signal de composante.

4. Dispositif (1) selon la revendication 3, dans lequel le cinquième élément d'évaluation (45) et/ou le sixième élément d'évaluation (46) sont une image d'addition.

5. Dispositif (1) selon l'une des revendications 2 à 4, dans lequel le premier élément d'évaluation (41) et/ou le deuxième élément d'évaluation (42) et/ou le troisième élément d'évaluation (43) et/ou le quatrième élément d'évaluation (44) sont des images de différence.

6. Dispositif (1) selon l'une des revendications 3 à 5, dans lequel
le premier signal de composante est un signal conisusoïdal par rapport à l'angle prédéterminé (α),
le deuxième signal de composante est un signal sinusoïdal par rapport à l'angle prédéterminé (α) et
le septième élément d'évaluation (47) est conçu pour générer le signal angulaire (48) correspondant à la position angulaire (ϕ) de la pièce (2) au moyen d'une fonction arc-tangente du premier signal de composante et du deuxième signal de composante.

7. Dispositif (1) selon l'une des revendications précédentes, dans lequel le nombre de pôles de l'aimant (10) est entier divisible par deux.

8. Dispositif (1) selon l'une des revendications précédentes, dans lequel l'aimant (10) est fixé sur la pièce rotative (2) et l'unité de capteur (30) est disposée en position fixe par rapport à l'aimant (10).

9. Dispositif (1) selon l'une des revendications 1 à 7, dans lequel l'aimant (10) est disposé en position fixe par rapport au capteur (30) et l'unité de capteur (30) est fixée à la pièce rotative (2).

10. Dispositif (1) selon l'une des revendications précédentes, dans lequel le plan de mesure (200) s'étend sensiblement perpendiculairement à l'axe de rotation (100).
